# FASCICULE DE BREVET EUROPEEN

(11) **EP 2 368 217 B1**
(45) Date de publication et mention de la délivrance du brevet: **02.01.2013**
(21) Numéro de dépôt: 09804282.3
(22) Date de dépôt: 21.12.2009
(51) Int. Cl.: G06K 19/077

(54) **PROCEDE DE FABRICATION D'UN ASSEMBLAGE DE PUCES A MOYENS D'EMISSION-RECEPTION RADIOFREQUENCE RELIEES MECANIQUEMENT AU MOYEN D'UN RUBAN**
VERFAHREN ZUR HERSTELLUNG EINER BAUGRUPPE VON CHIPS MITTELS MECHANISCH DURCH EIN BAND VERBUNDENER HOCHFREQUENZÜBERTRAGUNGS-EMPFANGSMITTEL
METHOD FOR MAKING AN ASSEMBLY OF CHIPS BY MEANS OF RADIOFREQUENCY TRANSMISSION-RECEPTION MEANS MECHANICALLY CONNECTED BY A BAND

(30) Priorité: 22.12.2008 FR 0807332
(43) Date de publication de la demande: 28.09.2011
(73) Titulaire: Commissariat à l'Énergie Atomique et aux Énergies Alternatives, 75015 Paris (FR)
(72) Inventeur: VICARD, Dominique, F-38190 Bernin (FR)
(74) Mandataire: Gris, Sébastien
(86) Numéro de dépôt international: PCT/FR2009/001469
(87) Numéro de publication internationale: WO 2010/072921

(56) Documents cités:
- EP-A- 1 069 645
- EP-A- 1 630 728
- EP-A- 1 788 514
- US-A1- 2003 136 503
- US-A1- 2007 146 135

## Description

### Domaine technique de l'invention

L'invention est relative à un procédé de fabrication d'un assemblage de puces équipées de moyens d'émission-réception radiofréquence.

### État de la technique

Des puces microélectroniques équipées de moyens d'émission-réception radiofréquence peuvent servir d'étiquettes électroniques RFID. Ces puces sont alors munies d'antennes et peuvent servir pour l'identification à distance d'objets.

Les applications classiques de telles étiquettes sont la gestion d'inventaire et la traçabilité. La partie active de ces puces est généralement très miniaturisée c'est-à-dire qu'elles peuvent faire moins de 400µm de côté. Malgré cette miniaturisation, ces puces nécessitent une antenne dont les dimensions sont de l'ordre de grandeur de la longueur d'onde correspondant à la fréquence de fonctionnement des puces. Classiquement, les parties actives d'une étiquette RFID sont réalisées sur une plaquette de silicium, chaque puce est alors découpée afin de la désolidariser des autres puces présentes sur la plaquette. Puis la puce est reportée sur un circuit imprimé comportant l'antenne nécessaire au fonctionnement de l'étiquette RFID. L'antenne est généralement réalisée sous la forme d'une piste métallique imprimée sur un substrat.

Dans certaines applications, les puces RFID peuvent être intégrées à des fibres pour former une feuille de papier. La puce doit alors être relativement mince, de l'ordre de 25µm en épaisseur (la puce et son antenne associée). Pour une telle épaisseur, les techniques actuelles de report de la puce sur son antenne ne sont pas très fiables, la probabilité de casse ou d'endommagement de la puce étant élevée.

Le document US2007/146135 décrit l'assemblage de composants RFID utilisant des rouleaux. Avant d'être attaché à une antenne, un composant est désolidarisé de son rouleau de support.

Le document EP1630728 décrit une pluralité de puces formées sur une surface et reliées entre elles en série par un élément filaire.

### Objet de l'invention

L'invention a pour objet un procédé de réalisation d'un assemblage de puces connectées mécaniquement entre elles, de façon souple, ne présentant pas les inconvénients de l'art antérieur.

Cet objet est atteint par les revendications annexées et plus particulièrement par le fait que le procédé comporte successivement :
- la réalisation, sur un substrat, d'une pluralité de puces, comportant chacune au moins une zone d'accueil,
- la connexion en série des zones d'accueil des puces de l'assemblage par un ruban plat électriquement isolant comportant une pluralité de motifs métalliques isolés électriquement les uns des autres, chaque motif formant au moins une partie d'une antenne plane, reliée électriquement au niveau d'au moins une zone de connexion de ladite antenne à une zone d'accueil correspondante,
- la désolidarisation des puces au niveau du substrat, lesdites puces étant reliées mécaniquement entre elles par ledit ruban.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 illustre une vue de dessus d'un substrat comportant les puces nécessaires à la réalisation du procédé.
Les figures 2, 3 et 4 illustrent une vue en coupe du substrat de la figure 1 selon les différentes étapes d'un premier mode de réalisation du procédé.
La figure 5 illustre un mode de réalisation particulier d'un ruban destiné à relier les puces du substrat.
La figure 6 illustre une variante de l'assemblage utilisant le ruban illustré à la figure 5.
Les figures 7, 8 et 9 illustrent un deuxième mode de réalisation du procédé d'assemblage.
Les figures 10, 11 et 12 illustrent un troisième mode de réalisation du procédé d'assemblage.

### Description de modes de réalisation préférentiels de l'invention

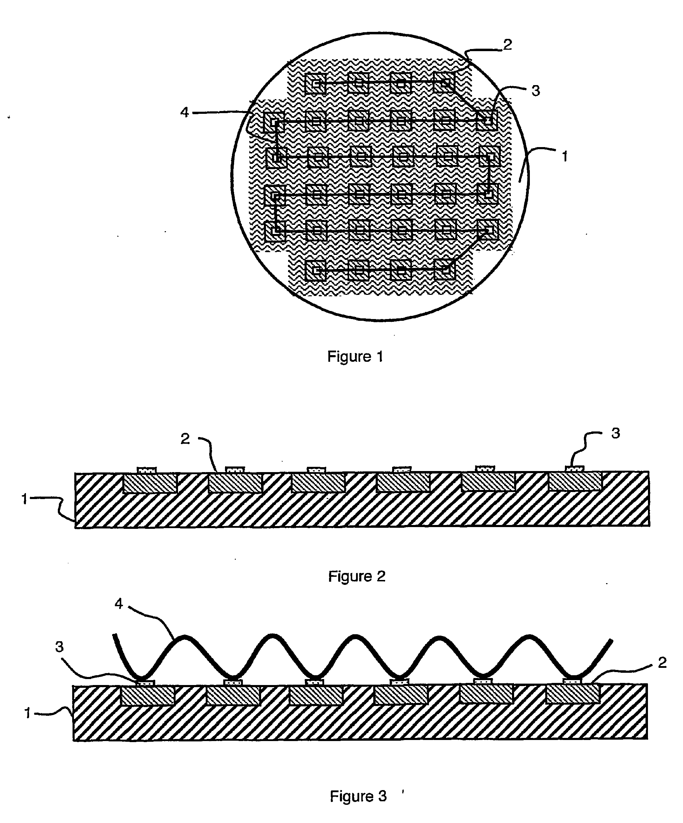

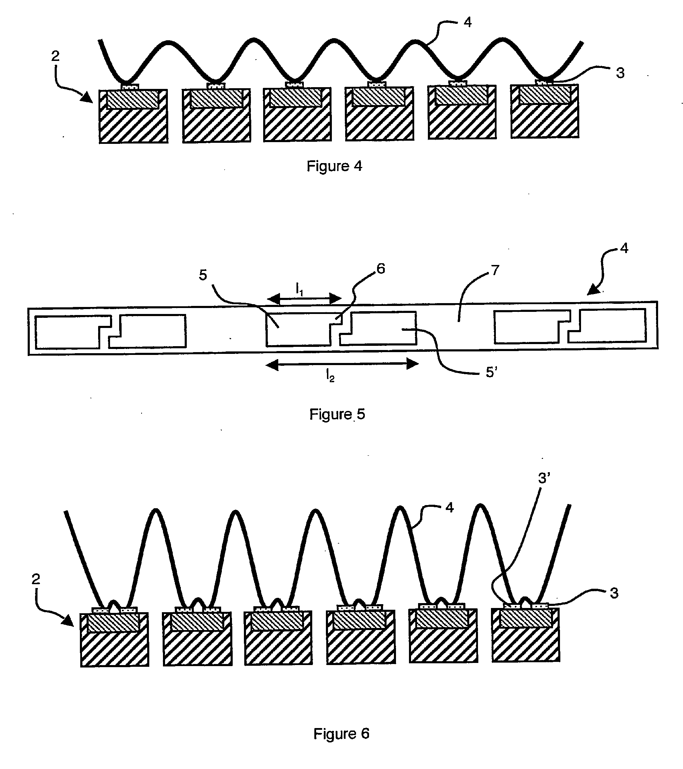

Comme illustré aux figures 1 à 3, une pluralité de puces 2 microélectroniques, équipées de moyens d'émission-réception radiofréquence destinées à former des étiquettes RFID, sont réalisées sur un substrat 1, qui peut être un substrat de silicium. Les puces peuvent être identiques ou non. Chaque puce 2 comporte au moins une zone d'accueil 3. Après la réalisation de la pluralité de puces 2 sur le substrat, ces dernières sont connectées en série au niveau des zones d'accueil 3 (figure 1) par un ruban 4 avant d'être désolidarisées au niveau du substrat 1. Après désolidarisation, les puces sont reliées mécaniquement entre elles par le ruban comme l'illustre la figure 4.

Lorsque les puces sont réalisées sur un substrat 1, elle peuvent être arrangées sous la forme de rangées, le substrat comporte alors une pluralité de rangées de puces sensiblement parallèles les unes aux autres. Le ruban 4 peut relier en série les puces d'une même rangée de puces, mais il est aussi possible de relier de la même manière une rangée adjacente avec un ruban 4 différent ou avec le même ruban 4 comme sur la figure 1. De préférence, la largeur du ruban 4 est déterminée de sorte qu'il n'y ait pas de recouvrement entre deux portions adjacentes de ruban 4, chacune associée à une rangée de puces, une fois les portions de ruban 4 solidarisées aux zones d'accueil 3 correspondantes. Lorsque le ruban 4 est placé sur la médiane d'une rangée de puces, ledit ruban 4 a, au maximum, une largeur égale à la largeur de la rangée, perpendiculairement à l'axe longitudinal du ruban 4, plus à l'écartement entre deux rangées de puces. Ainsi, le recouvrement précité est évité.

Le ruban reliant les puces 2 en série au niveau des zones d'accueil 4 est un ruban 4 plat électriquement isolant. Ce ruban 4 peut être un fil ou film en polymère à section rectangulaire. De préférence, le polymère utilisé est du polyester. Le ruban 4 comporte, comme illustré à la figure 5, une pluralité de motifs 5 métalliques isolés électriquement les uns des autres. Chaque motif 5 forme au moins une partie d'une antenne plane. Cette antenne est, de préférence, réalisée sur le ruban, c'est-à-dire qu'elle est coplanaire avec le ruban 4.

L'antenne plane est destinée à être reliée électriquement lors d'une étape de connexion en série aux puces. Cette connexion est réalisée au niveau d'au moins une zone de connexion 6 de ladite antenne à une zone d'accueil 3 d'une puce 2 correspondante. L'exemple de réalisation particulier de la figure 5 est un ruban destiné à former au niveau de chaque puce 2 une antenne dipolaire. Ainsi, une antenne selon la figure 5 est composée de deux motifs 5 et 5' métalliques électriquement isolés l'un de l'autre. Le ruban comporte une pluralité d'antennes espacées les unes des autres par un espace inter-antenne 7. Deux motifs adjacent formant une antenne comportent chacun une zone de connexion 6 destinée à relier, électriquement, respectivement deux zones d'accueil 3 et 3' d'une même puce 2 comme sur la figure 6. La longueur I₁ des motifs est choisie pour être adaptée à la longueur voulue de l'antenne associée à la puce comportant les moyens émission-réception radiofréquence. De préférence, la longueur totale I₂ des deux motifs 5 et 5', selon l'axe longitudinal du ruban 4, est de l'ordre de λ/2, où λ représente la longueur d'onde de la fréquence centrale de la bande d'émission-réception.

Comme sur la figure 6, le ruban 4 est apte à s'étirer verticalement par rapport au substrat, par exemple en fonction de la longueur de l'espace inter-antenne 7 et forme, par exemple, une demi-boucle entre deux puces adjacentes. Cet étirement vertical peut être réalisé lors de l'étape de connexion en série des puces, par exemple après connexion du ruban 4 sur une première puce et avant connexion du ruban 4 sur la zone d'accueil 3 de la puce adjacente.

L'espace inter-antenne 7 peut être déterminé en fonction du type d'application. À titre d'exemple, des longueurs plus importantes de l'espace inter-antenne 7 de liaison sont souhaitables pour permettre ultérieurement un stockage des puces, par exemple en bobine ou rouleau. Le ruban est donc, de préférence, souple afin de permettre la modulation de la longueur de l'espace inter-antenne 7 et le stockage en bobine ou rouleau.

Ainsi, lorsque les puces sont reliées en série par un ruban 4 au niveau du substrat 1, l'étirement vertical du ruban 4 par rapport au substrat 1 permet la réalisation de tout type d'espacement entre deux puces d'un rouleau. Autrement dit, lors de la connexion en série des zones d'accueil 3 de deux puces adjacentes, le ruban 4 est étiré verticalement par rapport au substrat entre les deux puces adjacentes de sorte qu'après désolidarisation des puces, les deux puces adjacentes soient séparées par un écartement prédéterminé.

À titre d'exemple, les motifs 5 sont réalisés par un dépôt métallique sur une surface du ruban 4, puis ce dépôt est structuré par gravure chimique ou par ablation locale du dépôt métallique ou par tout autre procédé connu de l'homme du métier. Tout type d'antenne peut être réalisé selon ce procédé. La taille et la forme du ou des motifs formant une antenne sont adaptés aux moyens d'émission-réception de la puce à relier et/ou de l'utilisation de l'étiquette RFID. Les motifs peuvent être réalisés en cuivre ou en aluminium.

L'étape de connexion en série des puces 2 peut être réalisée par déroulage du ruban au dessus des puces (figure 1) et par repérage de chaque zone de connexion 6 de l'antenne correspondant à la zone d'accueil 3 de la puce 2 à connecter. Ainsi, chaque zone de connexion 6 est mise en regard avec la zone d'accueil 3 correspondante avant collage ou soudage par ultrasons. Afin de faciliter un tel repérage, le ruban 4 est, de préférence, transparent. La transparence du ruban permet de réaliser le repérage de manière optique afin de disposer chaque zone de connexion 6 en regard avec la zone d'accueil 3 correspondante. Une fois la zone de connexion 6 mise en contact avec la zone d'accueil 3 correspondante, les deux zones sont alors solidarisées électriquement et mécaniquement par tout type de technique que l'homme du métier est susceptible d'utiliser en tenant compte des propriétés du ruban 4 et des motifs métalliques 5 (contraintes de température sur la matière du ruban, de solicitation, etc). À titre d'exemple, la solidarisation peut être effectuée par collage (colle électriquement conductrice) ou par soudure à ultrason. Le ruban 4 est, de préférence, maintenu en assurant le contact entre la zone de connexion 6 et la zone d'accueil 3 puis une vibration ultrasonore est exercée afin de réaliser la soudure. Lorsqu'une puce comporte deux zones d'accueil 3 (figure 6), les zones de connexion 6 de l'antenne associée peuvent être solidarisées concomitamment.

L'étape de connexion est effectuée au niveau de chaque puce 2. De préférence, le substrat comportant les puces 2 est associé à une table de correspondance des défauts déterminée lors d'une étape de tests électriques pendant la fabrication des puces 2. Ainsi, il est possible d'ignorer certaines puces défectueuses en ne les incorporant pas à l'assemblage si l'espace inter-antenne permet de relier la puce fonctionnelle suivante.

Comme illustré à la figure 4, le substrat est ensuite structuré de manière à désolidariser les puces les unes des autres au niveau du substrat. Les puces sont alors reliées en série uniquement par une connexion mécanique souple au moyen du ruban 4. La désolidarisation des puces 2 est réalisée dans le cas d'un substrat 1 massif de manière classique, par exemple par sciage, en prenant soin de ne pas sectionner le ruban 4 et de ne pas endommager les antennes.

Un tel procédé permet de faciliter la fixation entre le ruban et la pluralité de puces car toutes les puces sont initialement solidaires d'un même support rigide, constitué par le substrat. Cette opération se rapproche alors des techniques classiquement utilisées dans l'industrie microélectronique.

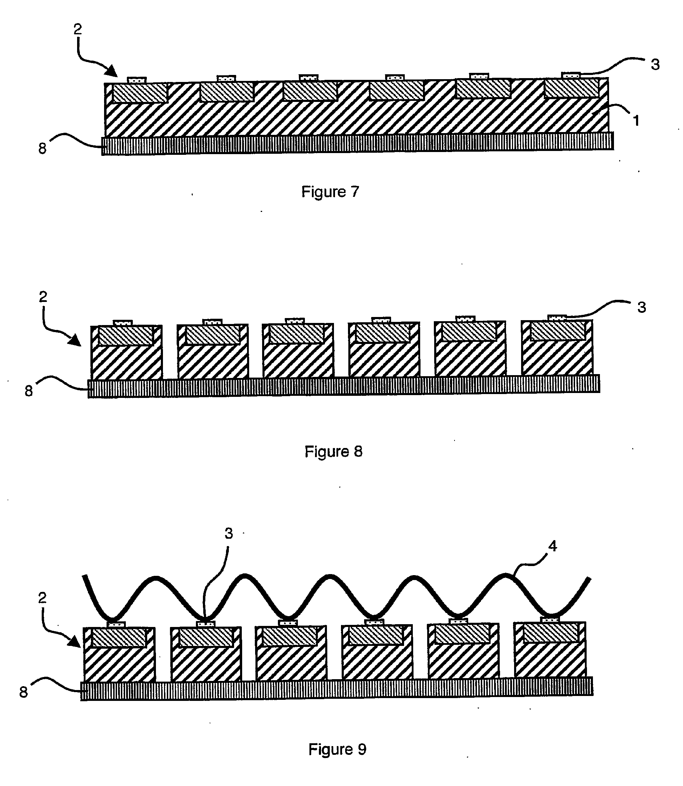

Dans un second mode de réalisation, illustré aux figures 7 à 9, le substrat 1 comporte un support provisoire 8, constituant un film de maintien (figure 7).

Ce support provisoire 8 est initialement déposé sur la face du substrat 1 opposée à celle comprenant les puces 2. Comme illustré à la figure 8, les puces 2 sont désolidarisées les unes des autres par découpe partielle jusqu'au support provisoire 8. Les puces 2 restent donc mécaniquement solidaires les unes des autres au niveau du substrat 1 par l'intermédiaire du support provisoire 8. Cette désolidarisation partielle des puces est réalisée par tout procédé adapté, par exemple, par sciage ou par gravure plasma.

Comme illustré à la figure 9, le ruban 4 est ensuite, comme précédemment, fixé à chacune des puces 2 au niveau de chaque zone d'accueil 3 en prenant soin de disposer la ou les zones de connexion 6 de l'antenne, associées à la puce 2, en regard de la ou des zones d'accueil 3 correspondantes avant d'effectuer la connexion électrique. Le support provisoire 8 est ensuite retiré et les puces ne sont alors reliées entre elles qu'au moyen de la connexion mécanique souple constituée par le ruban 4 (figure 4).

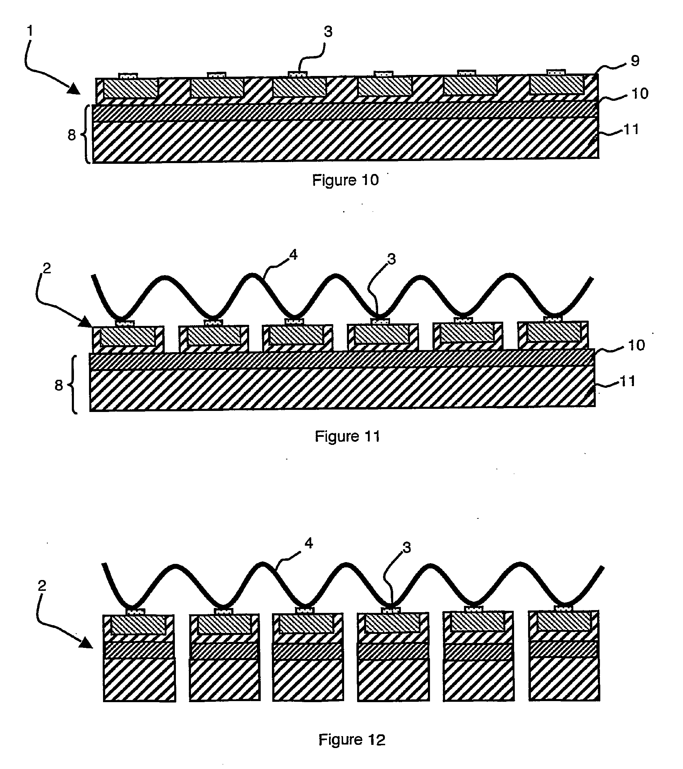

Dans un troisième mode de réalisation, illustré à la figure 10, les puces sont intégrées sur un substrat 1 de type substrat sur isolant (SOI). Celui-ci comporte classiquement un substrat actif 9 disposé sur un isolant enterré 10, formé sur un substrat de support 11. L'isolant enterré 10 et le substrat de support 11 constituent un support provisoire 8 du substrat 1. De manière analogue à la figure 8, sur la figure 11 les puces sont partiellement désolidarisées au niveau du substrat actif 9 et le ruban 4 fixé à chacune des puces. Les puces peuvent ensuite être désolidarisées du support provisoire 8, constitué par l'isolant enterré et le substrat de support 11, par exemple par gravure humide de l'isolant enterré 10 notamment au moyen d'acide fluorhydrique (figure 4). Il est également possible de désolidariser le support provisoire 8 par clivage (non représenté), ce dernier est alors solidaire de la puce, mais ne fournit plus aucune fonction mécanique comme sur la figure 12. Comme précédemment, les puces restent connectées entre elles uniquement par l'intermédiaire du ruban 4.

L'assemblage obtenu par les différents procédés décrits ci-dessus permet d'obtenir une pluralité de puces comportant chacune au moins une zone d'accueil 3. Les puces 2 sont connectées en série par le ruban 4 plat électriquement isolant comportant une pluralité de motifs 5 métalliques isolés électriquement les uns des autres. Chaque motif 5 forme au moins une partie d'une antenne plane reliée électriquement au niveau d'au moins une zone de connexion 6 de ladite antenne à une zone d'accueil 3 correspondante.

Les deuxième et troisième modes de réalisation montrent des puces comportant une zone d'accueil. Bien entendu, ces modes de réalisation peuvent aussi comporter deux zones d'accueil (comme sur la figure 6) ou plus au niveau de chaque puce.

De manière générale, un grand nombre de puces 2, formées sur un même substrat 1, c'est-à-dire une même plaquette, peuvent être connectées en série les unes aux autres par au moins un ruban 4 souple avant d'être désolidarisées les unes des autres au niveau du substrat 1. On obtient ainsi un assemblage de puces sous forme de guirlande souple, pouvant être stockée sous forme de bobine ou rouleau et être découpé à la demande au niveau de l'espace inter-antenne 7. L'assemblage est avantageusement enrobé par un polymère ou tout autre matériau permettant une protection vis-à-vis des agressions du milieu extérieur.

L'invention n'est pas limitée aux modes de réalisation décrits ci-dessus. En particulier, différents types de puces provenant de substrats distincts peuvent être connectés par un même ruban. Par ailleurs, la fabrication d'un assemblage peut utiliser une combinaison des caractéristiques décrites ci-dessus en relation avec les différents modes de réalisation.

Un tel procédé permet de relier des puces RFID à leurs antennes respectives de manière simple sans endommager les puces lors du raccordement. Ces puces peuvent alors être directement incorporées dans des feuilles de papier.

## Revendications

1. Procédé de fabrication d'un assemblage de puces (2) équipées de moyens d'émission-réception radiofréquence, comportant une étape de réalisation, sur un substrat (1), d'une pluralité de puces comportant chacune au moins une zone d'accueil (3), ledit procédé étant **caractérisé en ce qu'**il comporte successivement :
- la connexion en série des zones d'accueil (3) des puces (2) de l'assemblage par un ruban (4) plat électriquement isolant comportant une pluralité de motifs (5) métalliques isolés électriquement les uns des autres, chaque motif (5) formant au moins une partie d'une antenne plane, reliée électriquement au niveau d'au moins une zone de connexion (6) de ladite antenne à une zone d'accueil (3) correspondante et,
- la désolidarisation des puces (2) au niveau du substrat (1), lesdites puces étant reliées mécaniquement entre elles par ledit ruban (4).

2. Procédé selon la revendication 1 **caractérisé en ce que** chaque puce (2) comporte deux zones d'accueil (3), le ruban (4) comportant au niveau de chaque puce (2) deux motifs (5,5') respectivement reliés électriquement auxdites zones d'accueil (3,3') de ladite puce pour former une antenne dipolaire.

3. Procédé selon l'une des revendications 1 à 2, **caractérisé en ce que** la connexion en série est réalisée par déroulage du ruban (4) et par repérage de chaque zone de connexion (6) de l'antenne correspondant à la zone d'accueil (3) de la puce à connecter, chaque zone de connexion (6) étant mise en regard avec la zone d'accueil (3) correspondante avant collage ou soudage par ultrasons.

4. Procédé selon l'une quelconque des revendications 1 à 3, **caractérisé en ce que** le ruban (4) est un film polymère.

5. Procédé selon l'une quelconque des revendications 1 à 4 **caractérisé en ce que** le ruban (4) est souple et transparent.

6. Procédé selon l'une quelconque des revendications 1 à 5, **caractérisé en ce que** les motifs (5) sont en cuivre ou en aluminium.

7. Procédé selon l'une quelconque des revendications 1 à 6, **caractérisé en ce que** le substrat (1) comportant un support provisoire (8), le procédé comporte une étape de découpe partielle des puces (2), au niveau du substrat (1), avant la connexion en série des zones d'accueil (3), le support provisoire (8) étant éliminé lors de la désolidarisation des puces (2).

8. Procédé selon l'une quelconque des revendications 1 à 7, **caractérisé en ce que** l'assemblage de puces (2) forme une bobine.

9. Procédé selon l'une quelconque des revendications 1 à 8, **caractérisé en ce que** lors de la connexion en série des zones d'accueil (3) de deux puces adjacentes, le ruban (4) est étiré verticalement par rapport au substrat entre les deux puces adjacentes de sorte qu'après désolidarisation des puces, les deux puces adjacentes soient séparées par un écartement prédéterminé.

## Claims

1. A method for making an assembly of chips (2) equipped with radiofrequency transmission-reception means, comprising a step of making a plurality of chips, on a substrate (1), each chip comprising at least one reception area (3), said method being **characterized in that** it successively comprises:
- connecting reception areas (3) of the chips (2) of the assembly in series by means of an electrically insulating flat ribbon (4) comprising a plurality of metallic patterns (5) electrically insulated from one another, each pattern (5) forming at least a part of a flat antenna electrically connected at the level of at least one connection area (6) of said antenna to a corresponding reception area (3), and
- disuniting the chips (2) at the level of the substrate (1), said chips being mechanically connected to one another by said ribbon (4).

2. The method according to claim 1, **characterized in that** each chip (2) comprises two reception areas (3), the ribbon (4) at the level of each chip (2) comprising two patterns (5,5') respectively electrically connected to said reception areas (3, 3') of said chip to form a dipolar antenna.

3. The method according to one of claims 1 and 2, **characterized in that** series connection is performed by unrolling the ribbon (4) and by marking each connection area (6) of the antenna corresponding to the reception area (3) of the chip to be connected, each connection area (6) being placed facing the corresponding reception area (3) before bonding or ultrasonic welding.

4. The method according to one of claims 1 to 3, **characterized in that** the ribbon (4) is a polymer film.

5. The method according to any one of claims 1 to 4, **characterized in that** the ribbon (4) is flexible and transparent.

6. The method according to any one of claims 1 to 5, **characterized in that** the patterns (5) are made of copper or aluminum.

7. The method according to any one of claims 1 to 6, **characterized in that** the substrate (1) comprising a provisional support (8), the method comprises a step of partial slicing of the chips (2) at the level of the substrate (1) before connection of the reception areas (3) in series, the provisional support (8) being eliminated when disuniting the chips (2) is performed.

8. The method according to any one of claims 1 to 7, **characterized in that** the assembly of chips (2) forms a reel.

9. The method according to any one of claims 1 to 8, **characterized in that** when connection in series of the reception areas (3) of two adjacent chips (2) is performed, the ribbon (4) is stretched vertically with respect to the substrate between the two adjacent chips so that after the chips have been disunited, the two adjacent chips are separated by a predefined distance.

## Patentansprüche

1. Verfahren zur Herstellung einer Anordnung von Chips (2), die mit Funkfrequenz-Sende-/Empfangsmitteln ausgestattet sind, umfassend einen Schritt zur Herstellung einer Vielzahl von Chips auf einem Substrat (1), die jeweils wenigstens einen Aufnahmebereich (3) umfassen, wobei das Verfahren **dadurch gekennzeichnet ist, dass** es nacheinander umfasst:
- das In-Reihe-Verbinden der Aufnahmebereiche (3) der Chips (2) der Anordnung mittels eines elektrisch isolierenden flachen Bandes (4), das eine Vielzahl von elektrisch voneinander isolierten Metallmustern (5) umfasst, wobei ein jedes Muster (5) wenigstens einen Teil einer Flachantenne bildet, die im Bereich wenigstens eines Verbindungsbereichs (6) der Antenne mit einem entsprechenden Aufnahmebereich (3) elektrisch verbunden ist, und
- das Trennen der Chips (2) im Bereich des Substrats (1), wobei die Chips durch das Band (4) mechanisch untereinander verbunden sind.

2. Verfahren nach Anspruch 1, **dadurch gekennzeichnet, dass** ein jeder Chip (2) zwei Aufnahmebereiche (3) umfasst, wobei das Band (4) im Bereich eines jeden Chips (2) zwei Muster (5, 5') umfasst, die jeweils mit den Aufnahmebereichen (3, 3') des Chips elektrisch verbunden sind, um eine Dipolantenne zu bilden.

3. Verfahren nach einem der Ansprüche 1 bis 2, **dadurch gekennzeichnet, dass** das In-Reihe-Verbinden durch Abrollen des Bandes (4) und durch Lokalisieren eines jeden Verbindungsbereichs (6) der Antenne, der dem Aufnahmebereich (3) des zu verbindenden Chips entspricht, vollzogen wird, wobei ein jeder Verbindungsbereich (6) vor dem Kleben oder Ultraschallschweißen gegenüber dem entsprechenden Aufnahmebereich (3) angeordnet wird.

4. Verfahren nach einem der Ansprüche 1 bis 3, **dadurch gekennzeichnet, dass** das Band (4) ein Polymerfilm ist.

5. Verfahren nach einem der Ansprüche 1 bis 4, **dadurch gekennzeichnet, dass** das Band (4) flexibel und transparent ist.

6. Verfahren nach einem der Ansprüche 1 bis 5, **dadurch gekennzeichnet, dass** die Muster (5) aus Kupfer oder aus Aluminium bestehen.

7. Verfahren nach einem der Ansprüche 1 bis 6, **dadurch gekennzeichnet, dass**, wenn das Substrat (1) einen provisorischen Träger (8) umfasst, das Verfahren einen Schritt zum teilweisen Schneiden der Chips (2) im Bereich des Substrats (1) vor dem In-Reihe-Verbinden der Aufnahmebereiche (3) umfasst, wobei der provisorische Träger (8) beim Trennen der Chips (2) entfernt wird.

8. Verfahren nach einem der Ansprüche 1 bis 7, **dadurch gekennzeichnet, dass** die Anordnung von Chips (2) eine Spule bildet.

9. Verfahren nach einem der Ansprüche 1 bis 8, **dadurch gekennzeichnet, dass** bei dem In-Reihe-Verbinden der Aufnahmebereiche (3) von zwei benachbarten Chips das Band (4) zwischen den beiden benachbarten Chips vertikal zu dem Substrat gestreckt wird, so dass nach dem Trennen der Chips die beiden benachbarten Chips durch einen vorbestimmten Abstand getrennt sind.
